# EUROPEAN PATENT APPLICATION

(11) **EP 3 716 322 A1**
(43) Date of publication of application: **30.09.2020**
(21) Application number: 19877527.2
(22) Date of filing: 09.09.2019
(51) Int. Cl.: H01L 23/373, H01L 23/13, H01L 23/48, H01L 23/29, H01L 23/367

(54) **POWER SEMICONDUCTOR MODULE PACKAGE AND MANUFACTURING METHOD OF SAME**

(30) Priority: 28.01.2019 KR 20190010718
(71) Applicant: Lee, Min Hee, Yeonsu-gu, Incheon 21909 (KR)
(72) Inventor: LEE, Jeong Hwa, Incheon 21336 (KR); LEE, Min Hee, Incheon 21909 (KR)
(74) Representative: Swindell & Pearson Limited
(86) International application number: PCT/KR2019/011612
(87) International publication number: WO 2020/159031

(57) **Abstract**

The present invention may provide a power semiconductor module package having excellent performance in dissipating heat generated in a chip to the outside and a method for manufacturing the same. Particularly, disclosed are a power semiconductor module package in which heat generated in a chip is dissipated to upper, lower, and side portions of the chip through a base substrate and a cover substrate, which are made of a ceramic material including aluminum oxide or aluminum nitride. Specifically, a large amount of heat generated when a semiconductor power device such as an IGBT is driven is dissipated without damaging the power semiconductor module package, and a method for manufacturing the same.

## Description

### TECHNICAL FIELD

The present invention relates to a power semiconductor module package and a method for manufacturing the same, and more particularly, to a power semiconductor module package having superior performance of dissipating heat generated from the power semiconductor chips to the outside and a method for manufacturing the same.

### BACKGROUND ART

Power semiconductor chips such as such as MOSFETs, bipolar transistors, IGBTs, diodes, and the like constituting a power semiconductor module dissipate a large amount of heat generated during operating. If thermal expansion coefficients between bonding material and the power semiconductor chips provided in the module package are different from each other, package defects may occur, and thus, there is a problem in the instability of transmitted power occurs due to circuit damage. In particular, electric vehicles, high speed rail for express train, solar cells, and the like require stable and high power output of power semiconductor modules, and the demands are increasing in fields in which high-speed switching is required. In the related technical fields, needs for manners to improve package defects and quality degradation due to mismatch in thermal expansion are increasing.

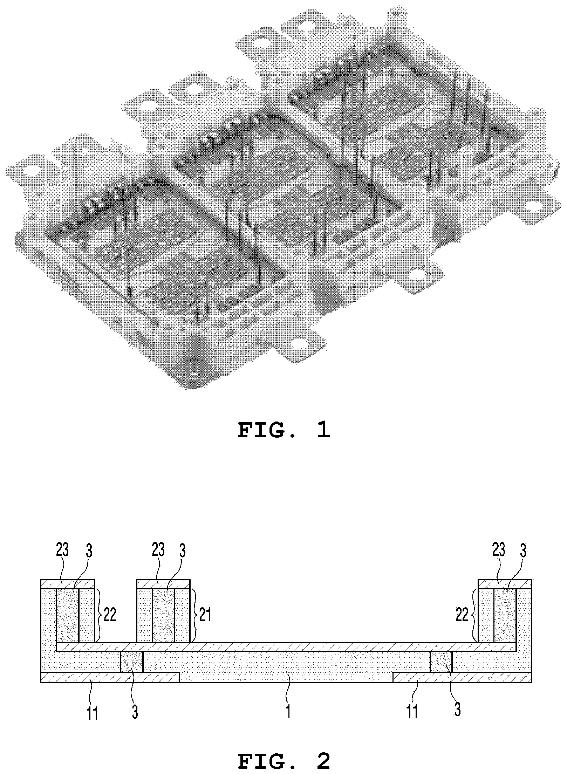

FIG. 1 is a photograph illustrating an example of an IGBT module according to the related art. As illustrated in FIG. 1, in the IGBT module according to the related art, plastic materials are used as sidewall and cover materials, unlike a substrate material. In the manufacturing process, a final IGBT module is completed after the plastic cover is assemble to IGBT module substrate which is separately manufactured.

In the IGBT module manufactured in this manner, the substrate, the sidewall (spacer), and the cover are made of materials different from each other to cause serious problems such as deterioration in durability, package defect, and the like by deformation due to external environments because of the difference in thermal expansion coefficient. In addition, since heat dissipation properties of the plastic material are poor, heat dissipation is performed only toward a lower end of the substrate. As a result, there is a limit in heat dissipation property of the entire package. For example, in case of a PGA type package, since a structure that is in a sintered state is used, when terminals are connected using pins, additional processes such as via-hole formation, soldering, and the like on the substrate are required.

Meanwhile, Korean Patent Publication No. 10-2009-0010166 discloses a power semiconductor module base including a heat dissipation substrate made of a high thermal conductive material, an insulation substrate bonded to a top surface of the heat dissipation substrate, a line layer installed on a top surface of the insulation substrate, and a heat dissipation fin bonded to a bottom surface of the heat dissipation substrate. However, in the power module base, heat has to be dissipated through only one side, it is difficult to realize miniaturization and precision of the component due to a large volume, and a resin material is employed as a casing material to make it difficult to solve the problem due to the difference in thermal expansion coefficient between the casing material and the substrate material.

### DISCLOSURE OF THE INVENTION

### TECHNICAL PROBLEM

The present invention provides a power semiconductor module package, which has excellent performance in dissipating a large amount of heat generated when a semiconductor power device such as an IGBT is driven and is manufactured by integrating a substrate, a sidewall, and a cover into one material, and a method for manufacturing the same.

### TECHNICAL SOLUTION

In order to solve the above problems, the present invention provides a power semiconductor module package comprising chips in a cavity between a base substrate and a cover substrate, wherein the base substrate includes a first thick film 1 having a via-hole filled with tungsten paste, a first tungsten paste layer below the first thick film, a second tungsten paste layer on the first thick film, a sidewall and a partition wall, each of which has a via-hole, which is filled with tungsten paste, on the second tungsten paste layer, and a third tungsten paste layer on upper portions of the sidewall and a partition wall, one portion of the first tungsten paste layer connected to the via-hole filled with the tungsten paste is not connected to the other portion of the first tungsten paste layer connected to the other via-hole filled with the tungsten paste, the cover substrate includes a second thick film and a fourth tungsten paste layer on the second thick film, a via-hole passing through the second thick film and the fourth tungsten paste layer is formed, the chip adheres to the cover substrate and the base substrate by using nano silver ink, and the first thick film, the sidewall, the partition wall, and the second thick film are made of a ceramic material including aluminum oxide or aluminum nitride as the same material.

Also, a nickel layer as a plated layer may be laminated on a portion of the first tungsten paste layer, which is connected to a connection terminal, and a nickel layer, a copper layer, and a gold layer as plated layers may be sequentially laminated on each of the second tungsten paste layer, the third tungsten paste layer, and the fourth tungsten paste layer.

Also, each of the first tungsten paste layer, the second tungsten paste layer, the third tungsten paste layer, and the fourth tungsten paste layer in addition to the plated layer may have a thickness of 100 *µ*m to 400 *µ*m.

Also, the power semiconductor module package may further include a connection terminal bonded to the nickel layer laminated on the first tungsten paste layer.

Also, the via-hole filled with the tungsten paste may have a diameter of 100 *µ*m to 400 *µ*m.

In order to solve further another problem, the present invention provides a method for manufacturing a power semiconductor module package provided with a cavity for the chip attachment chip between a base substrate and a cover substrate, wherein a step of preparing the base substrate includes: a step of forming a first thick film having a via-hole through tape casing and punching processes by using a ceramic sheet including aluminum oxide or aluminum nitride; a step of filling tungsten paste in the via-hole of the first thick film; a step of forming a first tungsten paste layer on a portion contacting the via-hole filled with the tungsten paste below the first thick film; a step of forming a second tungsten paste layer on a portion contacting the via-hole filled with the tungsten paste on the first thick film; a step of forming a sidewall and a partition wall, each of which has a via-hole, on the second tungsten paste layer and filling tungsten pasta in the via-hole to form a third tungsten paste layer on upper portions of the sidewall and the partition wall; a step of sintering the first thick film, on which the first tungsten paste layer and the second tungsten paste are formed, and the sidewall and the partition wall, on which the third tungsten paste layer is formed; and a step of forming a nickel layer as a plated layer on a portion of the first tungsten paste layer, which is connected to a connection terminal, and sequentially forming a nickel layer, a copper layer, and a gold layer as plated layers on the second tungsten paste layer and the third tungsten paste layer, a step of preparing the cover substrate includes: a step of forming a second thick film having a via-hole through tape casting and punching processes by using the ceramic sheet including aluminum oxide or aluminum nitride; a step of forming a fourth tungsten paste layer on a portion of the second thick film except for the via-hole; a step of sintering the second thick film on which the fourth tungsten paste layer is formed; and a step of sequentially forming a nickel layer, a copper layer, and a gold layer as plated layers on the sintered fourth tungsten paste layer, and a step of providing the chip between the base substrate and the cover substrate includes: a step of applying nano silver ink on a position, at which the chip will be disposed, on the second tungsten paste layer of the base substrate to apply heat and a pressure so that the chip adheres to the second tungsten paste layer; and a step of applying nano silver ink on an upper portion of the chip adhering to the third tungsten paste layer and the second tungsten paste layer, which are disposed on the upper portions of the sidewall and the partition wall to allow the cover substrate to contact the upper portions of the chip, the sidewall, and the partition wall so that the fourth tungsten paste layer of the cover substrate contacts the applied nano silver ink, thereby applying heat and a pressure so that the cover substrate adheres to the chip, the sidewall, and the partition wall, wherein each of the sidewall, the partition wall, and the second thick film is made of a ceramic material that is the same material as the first thick film.

Also, each of the first tungsten paste layer, the second tungsten paste layer, the third tungsten paste layer, and the fourth tungsten paste layer in addition to the plated layer may have a thickness of 100 *µ*m to 400 *µ*m.

Also, the via-hole filled with the tungsten paste may have a diameter of 100 *µ*m to 400 *µ*m.

Also, the method may further include a step of bonding the connection terminal to the first tungsten paste layer.

Also, the chip may include a power semiconductor.

### ADVANTAGEOUS EFFECTS

The present invention may provide the power semiconductor module package having the excellent performance in dissipating the heat generated in the chip to the outside and the method for manufacturing the same. Particularly, the heat generated in the chip may be dissipated to the upper, lower, and side portions of the chip through the base substrate and the cover substrate, which are made of the ceramic material including aluminum oxide or aluminum nitride. Specifically, the large amount of heat generated when the semiconductor power device such as the IGBT is driven may be dissipated without damaging the power semiconductor module package.

In addition, the base substrate and the cover substrate may be applied to allow the chip to be vertically connected to the circuit, thereby realizing the three-dimensional circuit.

In addition, the base substrate, the sidewall, and the cover may be made of the same material to be structurally integrated with each other, thereby solving the structural problems of the module package according to the related art, such as the problems in durability and heat dissipation property due to the difference in material of the base substrate, the sidewall, and the cover.

In addition, in the application as the PGA type package, when connecting the terminals using the pins, the pin may be attached by performing the simple process through the soldering or the brazing on the tungsten paste layer that is plated using nickel at the outside without performing the additional processes such as the via-hole formation, the soldering, and the like.

### BRIEF DESCRIPTION OF THE DRAWINGS

FIG. 1 is a photograph illustrating an example of an IGBT module according to a related art.
FIG. 2 is a cross-sectional view of a base substrate according to an embodiment of the present invention.
FIG. 3 is a cross-sectional view of a cover substrate according to an embodiment of the present invention.
FIG. 4 is a cross-sectional view of an SMD-type power semiconductor module package according to an embodiment of the present invention.
FIG. 5 is a cross-sectional view of a PGA-type power semiconductor module package according to an embodiment of the present invention.
FIG. 6 is a cross-sectional view of a lead frame-type power semiconductor module package according to an embodiment of the present invention.
FIG. 7 is a flowchart for explaining a method for manufacturing a power semiconductor module package according to an embodiment of the present invention.

### MODE FOR CARRYING OUT THE INVENTION

Hereinafter, preferred embodiments will be described in more detail with reference to the accompanying drawings. In the description of the prevent invention, when it is determined that detailed description of related known technologies may obscure the subject matter of the present invention, the detailed description will be omitted. In the drawings, parts that are not related to the description are omitted in order to clearly describe the present invention, similar reference numerals are assigned to similar parts throughout the specification, and detailed configuration directions of the present invention will be described with reference to the drawings. Also, in the entire specification, when it is described that one comprises (or includes or has) some elements, it should be understood that it may comprise (or include or has) only those elements, or it may comprise (or include or have) other elements as well as those elements if there is no specific limitation.

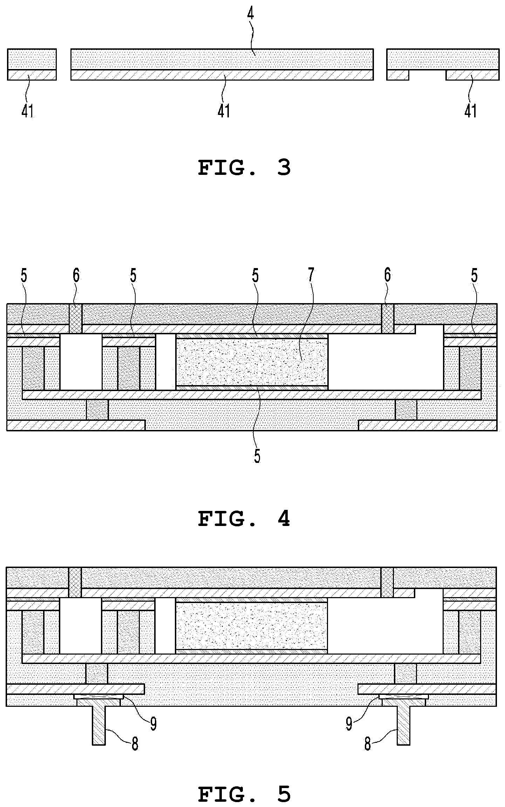

FIG. 2 is a cross-sectional view of a base substrate according to an embodiment of the present invention, FIG. 3 is a cross-sectional view of a cover substrate according to an embodiment of the present invention, and FIG. 4 is a cross-sectional view of an SMD-type power semiconductor module package according to an embodiment of the present invention.

Referring to FIGS. 2 to 4, the present invention relates to a power semiconductor module package provided with a chip between a base substrate and a cover substrate, and the base substrate includes a first thick film 1 having a via-hole 3 filled with tungsten paste, a first tungsten paste layer 11 below the first thick film 1, a second tungsten paste layer 12 on the first thick film 1, a sidewall 22 and a partition wall 21, each of which has a via-hole 3, which is filled with tungsten paste, on the second tungsten paste layer 12, and a third tungsten paste layer 23 on upper portions of the sidewall 22 and a partition wall 21. One portion of the first tungsten paste layer 11 connected to the via-hole 3 filled with the tungsten paste is not connected to the other portion of the first tungsten paste layer 11 connected to the other via-hole 3 filled with the tungsten paste, and the cover substrate includes a second thick film 4 and a fourth tungsten paste layer 41 on the second thick film 4. A via-hole 6 passing through the second thick film 4 and the fourth tungsten paste layer 41 is formed, and the chip 7 adheres to the cover substrate and the base substrate by using nano silver ink 5.

Here, in the present invention, the first thick film 1, the sidewall 22, the partition wall 21, and the second thick film 4 may be made of a ceramic material including aluminum oxide or aluminum nitride as the same material and be manufactured to be structurally integrated with each other. As a result, structural problems of the module package according to the related art, such as problems in durability and heat dissipation property due to a difference in material of the base substrate, the sidewall, and the cover may be solved at once.

Aluminum oxide has various purities and is the most common material among advanced ceramic materials. Aluminum oxide has properties of excellent electrical insulation (1x10¹⁴ Qcm to 1x10¹⁵ Ωcm), high mechanical strength (300 MPa to 630 MPa), high compressive strength (2,000 MPa to 4,000 MPa), high hardness (15 GPa to 19 GPa), general thermal conductivity (20 W/mK to 30 W/mK), high corrosion resistance and abrasion resistance, good gliding capacity, a low density (3.75 g/cm³ to 3.95 g/cm³), a high sintering temperature of 1,000°C to 1,800°C, bio-inertness, and food compatibility.

Aluminum nitride (AlN) is stable under an inert gas atmosphere, is melted at a temperature of about 2,800°C, and is decomposed around a temperature of 1,800°C in vacuum. Since a surface oxide layer is formed at a temperature of 700°C or more in the atmosphere, aluminum nitride (AlN) has stable properties up to a temperature of 1,370°C.

Also, aluminum nitride (AlN) has theoretical thermal conductivity (319 W/m·K) greater than at least 10 times that of alumina and also has excellent electrical insulation (9×10¹³ Ω·cm). Furthermore, aluminum nitride (AlN) has a thermal expansion coefficient (4×10⁻⁶) less than that of alumina and similar to that of an Si semiconductor and has superior mechanical strength (430 MPa).

Thus, in the present invention, the base substrate and the cover substrate may be made of aluminum oxide or aluminum nitride to dissipate a large amount of heat generated when the semiconductor power device such as IGBT is driven without damaging the chip package.

Also, the sidewall 22 may be installed to prevent foreign substances from being permeated from the outside, and the partition wall 21 may be installed to partition a space within the package so that the chip 7 is capable of being integrated. The sidewall 22 and the partition wall 21 may be made of the same material as the base substrate and the cover substrate to solve the problems in durability, package defect, heat dissipation property due to a difference in material of the substrate according to the related art and a spacer.

Also, the via-hole 3 filled with the tungsten paste is formed inside the sidewall 22 and the partition wall 21 to allow current to flow. Here, the via-hole 3 may have a diameter of 100 *µ*m to 400 *µ*m. If the via-hole 3 has a diameter less than 100 *µ*m, the current flow may not be smooth, and if the via-hole 3 has a diameter greater than 400 *µ*m, workability may be deteriorated.

Here, the base substrate, the cover substrate, the sidewall, and the partition wall may have thicknesses different from each other according to the types of used ceramic materials. In detail, when aluminum oxide is used as the ceramic material as a reference after sintering, the thickness may be 0.3 mm to 1.0 mm, and when aluminum nitride is used as the ceramic material, the thickness may be 0.5 mm to 1.0 mm.

A nickel layer as a plated layer may be laminated on a portion of the first tungsten paste layer 11, which is connected to a connection terminal, and a nickel layer, a copper layer, and a gold layer as plated layers may be sequentially laminated on each of the second tungsten paste layer 12, the third tungsten paste layer 23, and the fourth tungsten paste layer 41. The tungsten paste may withstand a high sintering temperature of aluminum oxide or aluminum nitride.

Here, the nickel layer may be formed on the tungsten paste layer in the plated form. Also, the nickel layer is required to form the copper layer. In addition, the copper layer may be formed as a circuit pattern that allows current to flow, and the gold layer may be laminated on the copper layer to prevent oxidation of the copper layer.

Each of the first tungsten paste layer 11, the second tungsten paste layer 12, the third tungsten paste layer 23, and the fourth tungsten paste layer 41 may have a thickness of 5 *µ*m to 7 *µ*m. When the thickness of each tungsten paste layer is too thin, each of the conductive layers may be delaminated by heat generated in the chip. On the other hand, when the thickness of each tungsten paste layer is too thick, each of the conductive layers may be delaminated by a thermal shock. Also, when each of the first tungsten paste layer, the second tungsten paste layer, the third tungsten paste layer, and the fourth tungsten paste layer includes the plated layer, the total thickness of each of the paste layers may be 100 *µ*m to 400 *µ*m.

In the case of the SMD-type package described above, the connection terminal may be directly bonded to the plated layer (nickel layer) formed on a portion of the first tungsten paste layer 11.

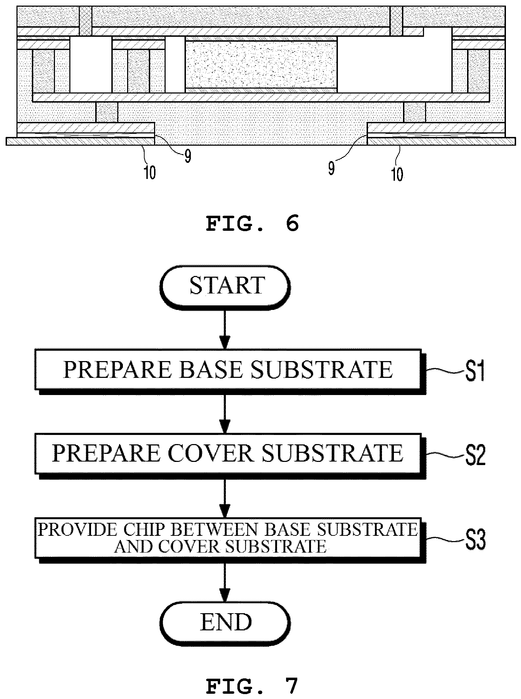

FIG. 5 is a cross-sectional view of a PGA-type power semiconductor module package according to an embodiment of the present invention, and FIG. 6 is a cross-sectional view of a lead frame-type power semiconductor module package according to an embodiment of the present invention.

Referring to FIGS. 5 and 6, a connection terminal such as a pin 8 or a lead frame 10 may be bonded to the first tungsten paste layer 11. The pin 8 or the lead frame 10 may be bonded by a simple process through formation of a general soldering or brazing bonding part 9.

One portion of the first tungsten paste layer 11 connected to one via-hole 3 filled with the tungsten paste may not be connected to the other portion of the first tungsten paste layer 11 connected to the other via-hole 3 filled with the tungsten paste, and thus, the connection terminals may serve as terminals having different polarities and be connected to the circuit.

An empty space between the base substrate and the cover substrate may be filled with silicon. Since the space between the substrates is filled with the silicon, short circuit between the circuit and the circuit may be prevented, the chip may be protected from external shocks, and the chip package may be secured in durability. After filling with the silicon, the via-hole of the second thick film 4 may be sealed with a ceramic material including aluminum oxide or aluminum nitride, which is the same material as the silicon.

In the present invention, the chip may be the semiconductor power device. When the semiconductor power device such as MOSFETs, bipolar transistors, IGBTs, and diodes is driven, a large amount of heat is generated. Thus, when the components included in the package have thermal expansion coefficients different from each other, package defects may occur, and instability of a transmitted voltage due to damage of a wavelength conversion means may occur. However, when the power semiconductor module package according to the present invention is used, heat generated in the semiconductor power device may be quickly dissipated upward and downward to solve the above-described problem. Thus, since the heat is dissipated vertically, the power semiconductor module package according to the present invention may be stacked vertically to realize integration of the circuit.

Hereinafter, a method for manufacturing the power semiconductor module package according to the present invention will be described in detail.

FIG. 7 is a flowchart for explaining a method for manufacturing a power semiconductor module package according to an embodiment of the present invention.

Referring to FIG. 7, a method for manufacturing a power semiconductor module package according to the present invention includes a step (S1) of preparing a base substrate, a step (S2) of preparing a cover substrate, and a step (S3) of providing a chip between the base substrate and the cover substrate.

The step (S1) of the preparing the base substrate includes: a step of forming a first thick film 1 having a via-hole 3 through tape casing and punching processes by using a ceramic sheet including aluminum oxide or aluminum nitride; a step of filling tungsten paste in the via-hole 3 of the first thick film; a step of forming a first tungsten paste layer 11 on a portion contacting the via-hole 3 filled with the tungsten paste below the first thick film 1; a step of forming a second tungsten paste layer 12 on a portion contacting the via-hole 3 filled with the tungsten paste on the first thick film 1; a step of forming a sidewall 22 and a partition wall 21, each of which has a via-hole 3, on the second tungsten paste layer 12 and filling tungsten pasta in the via-hole 3 to form a third tungsten paste layer 23 on upper portions of the sidewall 22 and the partition wall 21; a step of sintering the first thick film 1, on which the first tungsten paste layer 11 and the second tungsten paste 12 are formed, and the sidewall 22 and the partition wall 21, on which the third tungsten paste layer 23 is formed; and a step of forming a nickel layer as a plated layer on a portion of the first tungsten paste layer 11, which is connected to a connection terminal, and sequentially forming a nickel layer, a copper layer, and a gold layer as plated layers on the second tungsten paste layer 12 and the third tungsten paste layer 23.

Also, the step (S2) of preparing the cover substrate includes: a step of forming a second thick film 4 having a via-hole through tape casting and punching processes by using the ceramic sheet including aluminum oxide or aluminum nitride; a step of forming a fourth tungsten paste layer 41 on a portion of the second thick film 4 except for the via-hole; a step of sintering the second thick film 4 on which the fourth tungsten paste layer 41 is formed; and a step of sequentially forming a nickel layer, a copper layer, and a gold layer as plated layers on the sintered fourth tungsten paste layer 41.

Also, the step (S3) of providing the chip between the base substrate and the cover substrate includes: a step of applying nano silver ink 5 on a position, at which the chip 7 will be disposed, on the second tungsten paste layer 12 of the base substrate to apply heat and a pressure so that the chip adheres to the second tungsten paste layer 12; and a step of applying nano silver ink 5 on an upper portion of the chip adhering to the third tungsten paste layer 23 and the second tungsten paste layer 12, which are disposed on the upper portions of the sidewall 22 and the partition wall 21 to allow the cover substrate 7 to contact the upper portions of the chip 7, the sidewall 22, and the partition wall 21 so that the fourth tungsten paste layer 41 of the cover substrate contacts the applied nano silver ink 5, thereby applying heat and a pressure so that the cover substrate adheres to the chip 7, the sidewall 22, and the partition wall 21.

The method of forming the nickel layer, the copper layer, and the gold layer on the tungsten paste layer may performed through deposition and plating, but is not limited thereto.

Also, each of the first tungsten paste layer 11, the second tungsten paste layer 12, the third tungsten paste layer 23, and the fourth tungsten paste layer may have a thickness of 5 *µ*m to 7 *µ*m, and the via-hole filled with the tungsten paste may have a diameter of 100 *µ*m to 400 *µ*m. Also, when each of the first tungsten paste layer, the second tungsten paste layer, the third tungsten paste layer, and the fourth tungsten paste layer includes the plated layer, the total thickness of each of the paste layers may be 100 *µ*m to 400 *µ*m.

Also, a step of bonding the connection terminal to the first tungsten paste layer 11 may be further performed. The bonding method may be performed through soldering or brazing.

Also, in the present invention, the chip may be the semiconductor power device.

Preferred embodiments of the present invention have been described above in detail with reference to the drawings. The description of the present invention is intended to be illustrative, and those with ordinary skill in the technical field of the present invention pertains will be understood that the present invention can be carried out in other specific forms without changing the technical idea or essential features.

Accordingly, the scope of the present invention is defined by the appended claims rather than the foregoing description and the exemplary embodiments described therein. Various modifications made within the meaning of an equivalent of the claims of the invention and within the claims are to be regarded to be in the scope of the present invention.

*** Description of the Symbols**

| | |
|---|---|
| 1 : First thick film | 11 : First tungsten paste layer |
| 12 : Second tungsten paste layer | 21 : Partition wall |
| 22 : Sidewall | 23 : Third tungsten paste layer |
| 3 : Via-hole of base substrate | 4 : Second thick film |
| 41 : Fourth tungsten paste layer | 5 : Nano silver ink |
| 6 : Via-hole of cover substrate | 7 : Chip |
| 8 : Pin | 9 : Bonding part |
| 10 : Lead frame | |

## Claims

1. A power semiconductor module package comprising chips in a cavity between a base substrate and a cover substrate,
wherein the base substrate comprises a first thick film 1 having a via-hole filled with tungsten paste, a first tungsten paste layer below the first thick film, a second tungsten paste layer on the first thick film, a sidewall and a partition wall, each of which has a via-hole, which is filled with tungsten paste, on the second tungsten paste layer, and a third tungsten paste layer on upper portions of the sidewall and a partition wall,
one portion of the first tungsten paste layer connected to the via-hole filled with the tungsten paste is not connected to the other portion of the first tungsten paste layer connected to the other via-hole filled with the tungsten paste,
the cover substrate comprises a second thick film and a fourth tungsten paste layer on the second thick film,
a via-hole passing through the second thick film and the fourth tungsten paste layer is formed,
the chip adheres to the cover substrate and the base substrate by using nano silver ink, and
the first thick film, the sidewall, the partition wall, and the second thick film are made of a ceramic material comprising aluminum oxide or aluminum nitride as the same material.

2. The power semiconductor module package of claim 1, wherein a nickel layer as a plated layer is laminated on a portion of the first tungsten paste layer, which is connected to a connection terminal, and a nickel layer, a copper layer, and a gold layer as plated layers are sequentially laminated on each of the second tungsten paste layer, the third tungsten paste layer, and the fourth tungsten paste layer.

3. The power semiconductor module package of claim 2, wherein each of the first tungsten paste layer, the second tungsten paste layer, the third tungsten paste layer, and the fourth tungsten paste layer in addition to the plated layer has a thickness of 100 *µ*m to 400 *µ*m.

4. The power semiconductor module package of claim 2, further comprising a connection terminal bonded to the nickel layer laminated on the first tungsten paste layer.

5. The power semiconductor module package of claim 1, wherein the via-hole filled with the tungsten paste has a diameter of 100 *µ*m to 400 *µ*m.

6. A method for manufacturing a power semiconductor module package provided with a chip between a base substrate and a cover substrate,
wherein a step of preparing the base substrate comprises:
a step of forming a first thick film having a via-hole through tape casing and punching processes by using a ceramic sheet comprising aluminum oxide or aluminum nitride;
a step of filling tungsten paste in the via-hole of the first thick film;
a step of forming a first tungsten paste layer on a portion contacting the via-hole filled with the tungsten paste below the first thick film;
a step of forming a second tungsten paste layer on a portion contacting the via-hole filled with the tungsten paste on the first thick film;
a step of forming a sidewall and a partition wall, each of which has a via-hole, on the second tungsten paste layer and filling tungsten pasta in the via-hole to form a third tungsten paste layer on upper portions of the sidewall and the partition wall;
a step of sintering the first thick film, on which the first tungsten paste layer and the second tungsten paste are formed, and the sidewall and the partition wall, on which the third tungsten paste layer is formed; and
a step of forming a nickel layer as a plated layer on a portion of the first tungsten paste layer, which is connected to a connection terminal, and sequentially forming a nickel layer, a copper layer, and a gold layer as plated layers on the second tungsten paste layer and the third tungsten paste layer,
a step of preparing the cover substrate comprises:
a step of forming a second thick film having a via-hole through tape casting and punching processes by using the ceramic sheet including aluminum oxide or aluminum nitride;
a step of forming a fourth tungsten paste layer on a portion of the second thick film except for the via-hole;
a step of sintering the second thick film on which the fourth tungsten paste layer is formed; and
a step of sequentially forming a nickel layer, a copper layer, and a gold layer as plated layers on the sintered fourth tungsten paste layer, and
a step of providing the chip between the base substrate and the cover substrate comprises:
a step of applying nano silver ink on a position, at which the chip will be disposed, on the second tungsten paste layer of the base substrate to apply heat and a pressure so that the chip adheres to the second tungsten paste layer; and
a step of applying nano silver ink on an upper portion of the chip adhering to the third tungsten paste layer and the second tungsten paste layer, which are disposed on the upper portions of the sidewall and the partition wall to allow the cover substrate to contact the upper portions of the chip, the sidewall, and the partition wall so that the fourth tungsten paste layer of the cover substrate contacts the applied nano silver ink, thereby applying heat and a pressure so that the cover substrate adheres to the chip, the sidewall, and the partition wall,
wherein each of the sidewall, the partition wall, and the second thick film is made of a ceramic material that is the same material as the first thick film.

7. The method of claim 6, wherein each of the first tungsten paste layer, the second tungsten paste layer, the third tungsten paste layer, and the fourth tungsten paste layer in addition to the plated layer has a thickness of 100 *µ*m to 400 *µ*m.

8. The method of claim 6, wherein the via-hole filled with the tungsten paste has a diameter of 100 *µ*m to 400 *µ*m.

9. The method of claim 6, further comprising a step of bonding the connection terminal to the first tungsten paste layer.

10. The method of claim 6, wherein the chip comprises a power semiconductor.
